# EUROPÄISCHE PATENTANMELDUNG

(11) **EP 2 120 269 A2**
(43) Veröffentlichungstag der Anmeldung: **18.11.2009**
(21) Anmeldenummer: 09006246.4
(22) Anmeldetag: 08.05.2009
(51) Int. Cl.: H01L 31/06

(54) **Punktkontakt-Solarzelle**

(30) Priorität: 16.05.2008 DE 102008024053
(71) Anmelder: Deutsche Cell Gmbh, 09587 Freiberg/Sachsen (DE)
(72) Erfinder: Krause, Andreas, Dr., 01187 Dresden (DE); Bitnar, Bernd, Dr., 09599 Freiberg (DE); Neuhaus, Holger, Dr., 09599 Freiberg (DE); Bamberg, Frederick, 09599 Freiberg (DE)
(74) Vertreter: Rau, Albrecht

(57) **Zusammenfassung**

Ein Halbleiter-Bauelement (1) umfasst ein flächig ausgebildetes HalbleiterSubstrat (2) mit einer Vorderseite (3), einer dieser gegenüberliegenden Rückseite (4) und einer senkrecht auf diesen stehenden Flächennormalen (5), eine erste Kontakt-Struktur (9), welche elektrisch leitfähig ist und über mindestens einen punktförmigen Front-Kontakt (10) mit der Vorderseite (3) des Halbleiter-Substrats (2) in elektrischer Verbindung steht, und eine zweite Kontakt-Struktur (13), welche elektrisch leitfähig ist und mit der Rückseite (4) des Halbleiter-Substrats (2) in elektrischer Verbindung steht.

## Beschreibung

Die Erfindung betrifft ein Halbleiter-Bauelement und ein Solarzellen-Modul mit mindestens zwei derartigen Halbleiter-Bauelementen. Die Erfindung betrifft weiterhin ein Verfahren zur Herstellung eines Halbleiter-Bauelements.

Herkömmliche Solarzellen haben Kontakte auf ihrer Vorder- und ihrer Rückseite. Die geometrischen Details insbesondere der Kontakte auf der Vorderseite der Solarzelle haben einen großen Einfluss auf die elektrischen Eigenschaften sowie insbesondere den Wirkungsgrad der Solarzelle.

Der Erfindung liegt daher die Aufgabe zugrunde, ein Halbleiter-Bauelement sowie ein Solarzellen-Modul mit einer verbesserten Kontakt-Struktur zu schaffen. Der Erfindung liegt weiterhin die Aufgabe zugrunde, ein Verfahren zur Herstellung eines derartigen Halbleiter-Bauelements bereitzustellen.

Diese Aufgabe wird durch die Merkmale der Ansprüche 1, 11 und 13 gelöst. Der Kern der Erfindung besteht darin, eine Kontakt-Struktur auf der Vorderseite des Halbleiter-Bauelements über punktförmige Kontakte mit dem Halbleiter-Substrat elektrisch zu verbinden. Zur Herstellung der punktförmigen, elektrischen Kontakte ist es vorgesehen, mittels eines Lasers Öffnungen in eine erste Passivierungs-Schicht auf der Vorderseite des Halbleiter-Substrats einzubringen, in welche in einem nachfolgenden Metallisierungs-Verfahren eine Kontakt-Struktur eingebracht wird. Weitere vorteilhafte Ausgestaltungen der Erfindung ergeben sich aus den Unteransprüchen.

Merkmale und Einzelheiten der Erfindung ergeben sich aus der Beschreibung eines Ausführungsbeispiels anhand der Zeichnungen. Es zeigen:
- Fig. 1: einen Querschnitt durch ein Halbleiter-Bauelement gemäß einem ersten Ausführungsbeispiel,
- Fig. 2: einen Längsschnitt entlang der Linie II-II durch das Halblei- ter-Bauelement gemäß Fig. 1 und
- Fig. 3: einen Querschnitt durch ein Solarzellen-Modul mit zwei Halbleiter-Bauelementen gemäß Fig. 1.

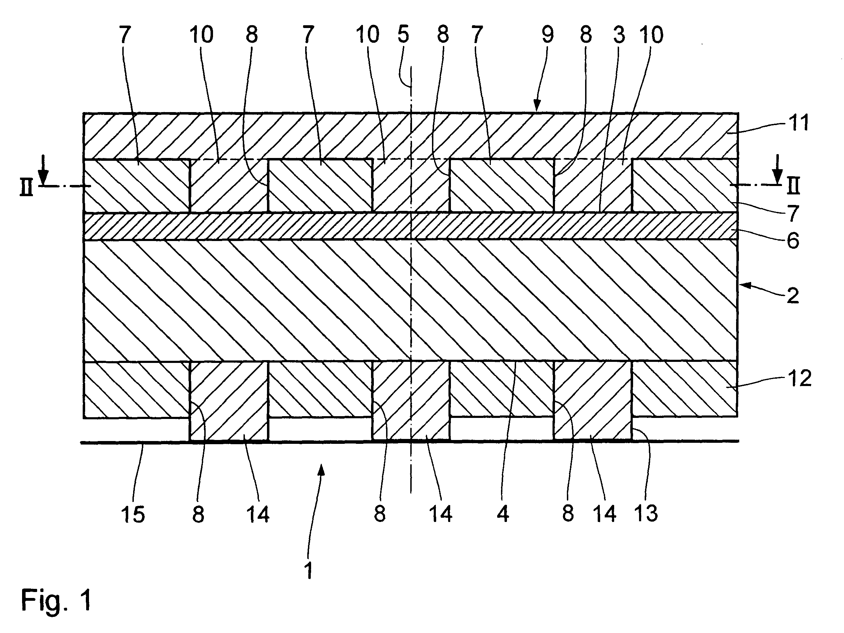

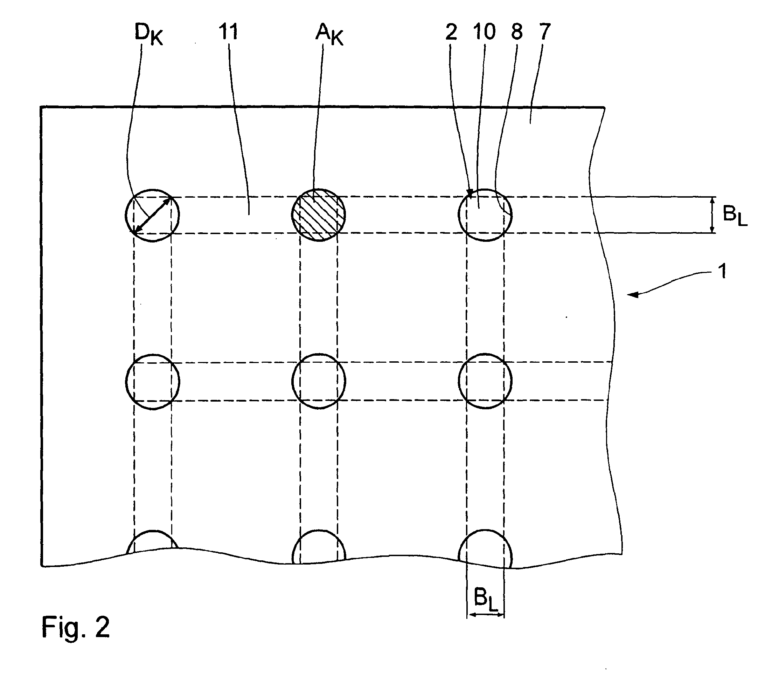

Im Folgenden wird unter Bezugnahme auf die Fig. 1 und 2 ein erstes Ausführungsbeispiel der Erfindung beschrieben. Ein Halbleiter-Bauelement 1 umfasst ein flächig ausgebildetes Halbleiter-Substrat 2 mit einer Vorderseite 3, einer dieser gegenüberliegenden Rückseite 4 und einer senkrecht auf der Vorderseite 3 und der Rückseite 4 stehenden Flächennormalen 5. Das Halbleiter-Bauelement 1 ist insbesondere als Solarzelle ausgebildet. Das Halbleiter-Substrat 2 ist aus einem Halbleiter-Material, insbesondere aus Silizium. Andere Halbleiter-Materialien sind jedoch ebenfalls denkbar. An der Vorderseite 3 ist ein als Emitter 6 dienender Bereich vorgesehen. Der Emitter 6 weist eine geeignete Dotierung auf. Auf der Vorderseite 3 des Halbleiter-Substrats 2 ist eine auch als Antireflexschicht dienende erste Passivierungs-Schicht 7 aufgebracht. Die erste Passivierungs-Schicht 7 ist elektrisch isolierend. Die erste Passivierungs-Schicht 7 ist vorzugsweise aus Siliziumnitrid. In der ersten Passivierungs-Schicht 7 ist eine Vielzahl von Öffnungen 8 eingebracht. Die Öffnungen 8 haben Abmessungen senkrecht zur Flächennormalen 5, welche im Verhältnis zu den Abmessungen des Halbleiter-Substrats 2 sehr klein sind. Sie werden daher im Folgenden als punktförmig bezeichnet. Die Öffnungen 8 sind insbesondere kreisförmig.

Außerdem umfasst das Halbleiter-Bauelement 1 eine erste Kontakt-Struktur 9, welche elektrisch leitfähig ist und über Front-Kontakte 10 in den Öffnungen 8 mit der Vorderseite 3 des Halbleiter-Substrats 2 in elektrischer Verbindung steht. Die Front-Kontakte 10 füllen die Öffnungen 8 vollständig aus. Sie werden daher im Folgenden ebenfalls als punktförmig bezeichnet. Die Front-Kontakte 10 haben wir die Öffnungen 8 einen Durchmesser D_{K} und eine Fläche A_{K} im Bereich von 10 µm² bis 10000 µm², insbesondere im Bereich von 100 µm² bis 1000 µm². Die erste Kontakt-Struktur 9 umfasst mindestens eine Schicht aus Nickel, Kobalt, Kupfer, Silber, Zinn oder einer Kombination dieser Elemente. Die erste Kontakt-Struktur 9 ist insbesondere mehrschichtig ausgebildet. Bezüglich des genauen Aufbaus der ersten Kontakt-Struktur 9 sei auf die DE 10 1007 031 958.6 verwiesen.

Die Öffnungen 8 mit den Front-Kontakten 10 sind in parallel zueinander angeordneten Reihen angeordnet. Sie sind insbesondere äquidistant zueinander angeordnet. Die punktförmigen Front-Kontakte 10 sind somit an den Eckpunkten eines regulären, insbesondere eines quadratischen Gitters angeordnet.

Außerdem umfasst die erste Kontakt-Struktur 9 linienförmige Leiterbahnen 11. Die Leiterbahnen 11 überdecken jeweils eine Reihe der Front-Kontakte 10, mit welchen sie in elektrischem Kontakt stehen. Die Leiterbahnen 11 weisen eine Breite B_{L} auf, welche vorzugsweise größer ist als der Durchmesser D_{K} der Front-Kontakte 10. Das Verhältnis B_{L} : D_{K} beträgt höchstens 2, insbesondere höchstens 1,5.

Um die Abschattung der Vorderseite 3 durch die erste Kontakt-Struktur 9 zu verringern, können die Leiterbahnen 11 jedoch ebenso schmaler als der Durchmesser D_{K} der Front-Kontakte 10 sein. Dieser Fall ist in Fig. 2 gezeigt.

Des Weiteren ist auf der Rückseite 4 des Halbleiter-Substrats 2 eine zweite Passivierungs-Schicht 12 vorgesehen. Die zweite Passivierungs-Schicht 12 ist aus Siliziumdioxid. Alternativ hierzu kann die zweite Passivierungs-Schicht 12 auch aus Siliziumnitrid, amorphem Silizium oder als Schichtsystem aus mindestens zwei dieser Stoffe ausgebildet sein.

Entsprechend der vorderseitigen, ersten Kontakt-Struktur 9 weist das Halbleiter-Bauelement 1 eine zweite Kontakt-Struktur 13 auf, welche elektrisch leitfähig ist und mit der Rückseite 4 des Halbleiter-Substrats 2 in elektrischer Verbindung steht. Hierzu sind wie auf der Vorderseite 3 Öffnungen 8 in der zweiten Passivierungs-Schicht 12 vorgesehen. Die Öffnungen 8 in der zweiten Passivierungs-Schicht 12 sind vorzugsweise wie die Öffnungen 8 in der ersten Passivierungs-Schicht 7 ausgebildet. Die zweite Kontakt-Struktur 13 steht somit über punktförmige Rückseiten-Kontakte 14 mit dem Halbleiter-Substrat 2 in elektrischer Verbindung.

Die Front-Kontakte 10 und die Rückseiten-Kontakte 14 sind derart angeordnet, dass jeweils einer der punktförmigen Front-Kontakte 10 und einer der punktförmigen Rückseiten-Kontakte 14 in Richtung der Flächennormalen 5 miteinander fluchten.

Die zweite Kontakt-Struktur 13 umfasst außerdem eine elektrisch leitende Folie 15. Die Folie 15 steht in elektrischem Kontakt mit den Rückseiten-Kontakten 14. Sie ist hierzu mit diesen verlötet oder mittels eines Leitklebers verklebt. Die Folie 15 ist auf ihrer dem Halbleiter-Substrat 2 zugewandten Seite reflektierend ausgebildet. Somit wird das Licht, welches das Halbleiter-Bauelement 1 durchstrahlt, von der Folie 15 reflektiert, wodurch der Wirkungsgrad des Halbleiter-Bauelements 1 weiter verbessert wird.

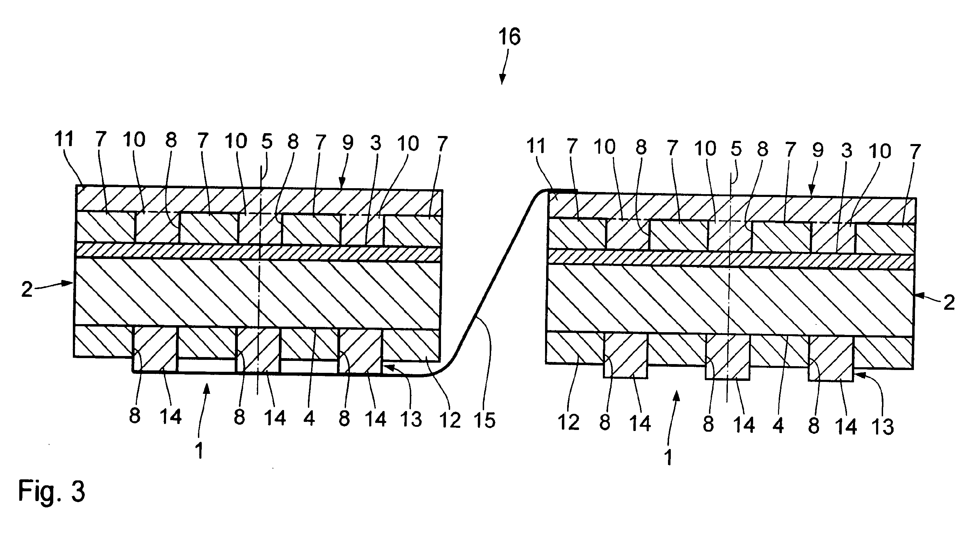

Im Folgenden wird unter Bezugnahme auf die Fig. 3 ein Solarzellen-Modul 16 beschrieben. Das Solarzellen-Modul 16 umfasst mindestens zwei Halbleiter-Bauelemente 1 gemäß den Ausführungsbeispielen der Erfindung. Die Halbleiter-Bauelemente 1 sind elektrisch miteinander verbunden. Sie sind insbesondere in Reihe geschaltet. Hierzu ist jeweils die Folie 15 der zweiten Kontakt-Struktur 13 auf der Rückseite 4 eines Halbleiter-Bauelements 1 mit der ersten Kontakt-Struktur 9 des benachbarten Halbleiter-Bauelements 1 elektrisch leitend verbunden. Die Folie 15 ist hierzu mit der ersten Kontakt-Struktur 9 verlötet oder mittels eines Leitklebers verklebt.

Im Folgenden wird ein Verfahren zur Herstellung des Halbleiter-Bauelements 1 beschrieben. Als Ausgangspunkt für das Verfahren zur Herstellung des Halbleiter-Bauelements 1 dient das Halbleiter-Substrat 2, insbesondere ein Siliziumwafer, mit dem Emitter 6 auf der Vorderseite 3. Zur Passivierung wird das Halbleiter-Substrat 2 auf der Vorderseite 3 und der Rückseite 4 mit Siliziumnitrid und/oder Siliziumdioxid und/oder amorphem Silizium beschichtet. Hiernach ist das Halbleiter-Substrat 2 auf der Vorderseite 3 vollständig von der ersten Passivierungs-Schicht 7 überdeckt. Ebenso ist das Halbleiter-Substrat 2 nach der Passivierung auf der Rückseite 4 vollständig von der zweiten Passivierungs-Schicht 12 überdeckt.

Sodann werden die Öffnungen 8 mittels eines Lasers in die erste Passivierungs-Schicht 7 eingebracht. Der Laser wird hierzu gepulst betrieben. Zum Einbringen der Öffnungen 8 ist erfindungsgemäß ein flüssigkeitsstrahl-geführter Laser vorgesehen. Hierbei wird der Laserstrahl mittels Totalreflexion an der Flüssigkeit-Luft-Grenzfläche eines Flüssigkeitsstrahls in diesem als flüssigen, faseroptischen Wellenleiter dienenden Flüssigkeitsstrahl geführt. Mit Hilfe eines derartigen flüssigkeitsstrahl-geführten Lasers lassen sich selbst Öffnungen 8 mit einem Durchmesser D_{K} von wenigen µm präzise und kontrolliert in die erste Passivierungs-Schicht 7 einbringen. Durch die geringe Fläche A_{K} der Front-Kontakte 10 ist eine verbesserte Passivierung der Vorderseite 3 des Halbleiter-Substrats 2 im Vergleich zu Halbleiter-Bauelementen mit linienförmigen Kontakten möglich. Eine derart verbesserte Passivierung hat eine höhere erreichbare Spannung zur Folge.

Vorzugsweise enthält der Flüssigkeitsstrahl Dotierstoffe wie beispielsweise Phosphor, Arsen, Antimon oder deren Verbindungen. Hierdurch wird beim Einbringen der Öffnungen 8 in die erste Passivierungs-Schicht 7 außerdem eine Dotierung des Halbleiter-Substrats 2 im Bereich der Öffnungen 8 erreicht.

Auf entsprechende Weise werden die Öffnungen 8 in die zweite Passivierungs-Schicht 12 auf der Rückseite 4 des Halbleiter-Substrats 2 eingebracht. Allerdings enthält der Flüssigkeitsstrahl zum Einbringen der Öffnungen 8 in die zweite Passivierungs-Schicht 12 auf der Rückseite 4 des Halbleiter-Substrats 2 als Dotierstoffe Bor, Indium, Aluminium, Gallium oder deren Verbindungen zur Ausbildung eines sogenannten Back-Surface-Fields (Rückseiten-Feldes) im Bereich der Rückseite 4 des Halbleiter-Substrats 2.

Durch die Dotierstoffe im Flüssigkeitsstrahl wird die Kontaktherstellung zwischen dem Halbleiter-Substrat 2 und den Kontakt-Strukturen 9, 13 erleichtert.

Nach Einbringen der Öffnungen 8 in die Passivierungs-Schichten 7, 12 wird die erste Kontakt-Struktur 9 auf die Vorderseite 3 des Halbleiter-Substrats 2 aufgebracht. Hierzu ist ein Druckverfahren, insbesondere ein Extrusions-Druckverfahren, vorgesehen. Ink-Jet-Druckverfahren, Aerosol-Druckverfahren oder Sieb-Druckverfahren sind jedoch ebenfalls möglich. Die aufgedruckten Leiterbahnen 11 füllen hierbei die Öffnungen 8 vollständig aus und bilden somit die Front-Kontakte 10, welche in elektrischem Kontakt mit der Vorderseite 3 des Halbleiter-Substrats 2 stehen.

Die Öffnungen 8 in der zweiten Passivierungs-Schicht 12 auf der Rückseite 4 des Halbleiter-Substrats 2 werden durch ein chemisches Metallisierungsverfahren punktweise metallisiert. Zur Metallisierung dienen insbesondere Nickel, Kobalt, Kupfer, Silber, Zinn oder eine Kombination dieser Stoffe. Anstelle eines chemischen Metallisierungsverfahrens kann auch ein galvanisches, insbesondere ein lichtinduziertes galvanisches Verfahren vorgesehen sein.

Schließlich werden die Rückseiten-Kontakte 14 mittels der gut leitfähigen Folie 15 elektrisch miteinander verbunden. Hierzu wird die Folie 15 mit den Rückseiten-Kontakten 14 verlötet oder mittels eines Leitklebers verklebt.

Zur Herstellung von Solarzellen-Modulen 16 mit mehreren Halbleiter-Bauelementen 1 wird die mit den Rückseiten-Kontakten 14 eines Halbleiter-Bauelements 1 elektrisch verbundene Folie 15 mit der ersten Kontakt-Struktur 9 auf der Vorderseite 3 eines benachbarten Halbleiter-Bauelements 1 elektrisch leitend verbunden, insbesondere verlötet oder mittels eines Leitklebers verklebt.

In einer alternativen, nicht in den Figuren dargestellten Ausführungsform sind die Front-Kontakte 10 und die Rückseiten-Kontakte 14 in Richtung der Flächennormalen 5 jeweils überschneidungsfrei zueinander angeordnet.

## Patentansprüche

1. Halbleiter-Bauelement (1) umfassend
a. ein flächig ausgebildetes Halbleiter-Substrat (2) mit
i. einer Vorderseite (3),
ii. einer dieser gegenüberliegenden Rückseite (4) und
iii. einer senkrecht auf diesen stehenden Flächennormalen (5),
b. eine erste Kontakt-Struktur (9), welche
i. elektrisch leitfähig ist und
ii. über mindestens einen punktförmigen Front-Kontakt (10) mit der Vorderseite (3) des Halbleiter-Substrats (2) in elektrischer Verbindung steht, und
c. eine zweite Kontakt-Struktur (13), welche
i. elektrisch leitfähig ist und
ii. mit der Rückseite (4) des Halbleiter-Substrats (2) in elektrischer Verbindung steht.

2. Halbleiter-Bauelement (1) gemäß Anspruch 1, **dadurch gekennzeichnet, dass** die punktförmigen Front-Kontakte (10) eine Kontakt-Fläche A_{K} im Bereich von 10 µm² bis 10000 µm², insbesondere im Bereich von 100 µm² bis 1000 µm² aufweisen.

3. Halbleiter-Bauelement (1) gemäß einem der vorhergehenden Ansprüche, **dadurch gekennzeichnet, dass** die zweite Kontakt-Struktur (13) über punktförmige Rückseiten-Kontakte (14) mit dem Halbleiter-Substrat (2) in elektrischer Verbindung steht.

4. Halbleiter-Bauelement (1) gemäß Anspruch 3, **dadurch gekennzeichnet, dass** jeweils einer der punktförmigen Front-Kontakte (10) und einer der punktförmigen Rückseiten-Kontakte (14) in Richtung der Flächennormalen (5) fluchtend zueinander angeordnet sind.

5. Halbleiter-Bauelement (1) gemäß Anspruch 3, **dadurch gekennzeichnet, dass** die punktförmigen Front-Kontakte (10) und die punktförmigen Rückseiten-Kontakte (14) in Richtung der Flächennormalen (5) jeweils überschneidungsfrei zueinander angeordnet sind.

6. Halbleiter-Bauelement (1) gemäß einem der vorhergehenden Ansprüche, **dadurch gekennzeichnet, dass** die punktförmigen Front-Kontakte (10) in Öffnungen (8) in einer Anti-Reflex-Schicht (7) angeordnet sind.

7. Halbleiter-Bauelement (1) gemäß einem der vorhergehenden Ansprüche, **dadurch gekennzeichnet, dass** die punktförmigen Front-Kontakte (10) in parallel zueinander angeordneten Reihen angeordnet sind.

8. Halbleiter-Bauelement (1) gemäß einem der vorhergehenden Ansprüche, **dadurch gekennzeichnet, dass** die punktförmigen Front-Kontakte (10) an den Eckpunkten eines regulären, insbesondere eines quadratischen Gitters angeordnet sind.

9. Halbleiter-Bauelement (1) gemäß einem der vorhergehenden Ansprüche, **dadurch gekennzeichnet, dass** die zweite Kontakt-Struktur (13) eine elektrisch leitende Folie (15) umfasst.

10. Halbleiter-Bauelement (1) gemäß Anspruch 9, **dadurch gekennzeichnet, dass** die Folie (15) zumindest auf ihrer dem Halbleiter-Substrat (2) zugewandten Seite reflektierend ausgebildet ist.

11. Solarzellen-Modul (16) mit mindestens zwei Halbleiter-Bauelementen (1) gemäß einem der vorhergehenden Ansprüche, welche elektrisch miteinander verbunden sind.

12. Solarzellen-Modul (16) gemäß Anspruch 11, **dadurch gekennzeichnet, dass** die Halbleiter-Bauelemente (1) jeweils mittels einer elektrisch leitfähigen Verbindung der Folie (15) eines der Halbleiter-Bauelemente (1) mit der ersten Kontakt-Struktur (9) des benachbarten Halbleiter-Bauelements (1) in Reihe geschaltet sind.

13. Verfahren zur Herstellung eines Halbleiter-Bauelements (1) umfassend die folgenden Schritte:
- Bereitstellen eines flächigen Halbleiter-Substrats (2) mit
- - einer Vorderseite (3),
- - einer Rückseite (4) und
- - mindestens einer auf der Vorderseite (3) angeordneten, elektrisch isolierenden, ersten Passivierungs-Schicht (7),
- Einbringen von Öffnungen (8) in die erste Passivierungs-Schicht (7) mittels eines Lasers,
- Aufbringen einer ersten Kontakt-Struktur (9) auf die Vorderseite (3) des Halbleiter-Substrats (2),
- wobei die erste Kontakt-Struktur (9) im Bereich der Öffnungen (8) mit dem Halbleiter-Substrat (2) in elektrischer Verbindung steht.

14. Verfahren gemäß Anspruch 13, **dadurch gekennzeichnet, dass** zum Einbringen der Öffnungen (8) ein flüssigkeitsstrahl-geführter Laser vorgesehen ist.

15. Verfahren gemäß Anspruch 14, **dadurch gekennzeichnet, dass** mittels des flüssigkeitsstrahl-geführten Lasers im Bereich der Öffnungen (8) ein Dotierstoff in das Halbleiter-Substrat (2) eingebracht wird.
